# EUROPEAN PATENT APPLICATION

(11) **EP 4 580 377 A1**
(43) Date of publication of application: **02.07.2025**
(21) Application number: 23857596.3
(22) Date of filing: 28.07.2023
(51) Int. Cl.: H10K 71/00, H10K 71/16, C23C 14/04

(54) **DEPOSITION MASK FOR OLED PIXEL DEPOSITION**

(30) Priority: 24.08.2022 KR 20220106423
(71) Applicant: LG INNOTEK CO. LTD, Gangseo-gu Seoul 07796 (KR)
(72) Inventor: LEE, Seung Heon, Seoul 07796 (KR); UM, Tae In, Seoul 07796 (KR)
(74) Representative: M. Zardi & Co S.A.
(86) International application number: PCT/KR2023/011087
(87) International publication number: WO 2024/043560

(57) **Abstract**

A deposition mask comprising; a metal plate including a deposition region and a non-deposition region, wherein the deposition region includes at least one effective portion; wherein the effective portion includes a plurality of unit through-holes, wherein the unit through-holes include a small area hole formed on a first surface of the metal plate; a large area hole formed on a second surface of the metal plate; and a connecting portion connecting the small area hole and the large area hole, wherein a rib is disposed between unit through-holes adjacent in the first direction, wherein an island portion is disposed between the unit through-holes adjacent in the second direction, wherein the island portion includes a first island portion and a second island portion spaced apart from each other, wherein the first island portion contacts the rib, wherein the second island portion is spaced apart from the rib.

## Description

### [Technical Field]

An embodiment relates to a deposition mask for OLED pixel deposition.

### [Background Art]

Display devices are applied to various devices. For example, the display device is applied to a small device such as a smart phone or a tablet PC. Alternatively, the display device is applied to a large-sized device such as a TV, monitor, or public display. Recently, the demand for ultra-high definition (UHD) of 500 pixels per inch (PPI) or more is increasing. Accordingly, display devices having high resolution are being applied to small devices and large devices.

Display devices are classified into liquid crystal display (LCD) and organic light emitting diode (OLED) according to driving methods.

The LCD is a display device driven using liquid crystal. In addition, OLED is a display device driven by using an organic material.

The OLED can express an infinite contrast ratio, has a response speed that is 1000 times faster than LCD, and has an excellent viewing angle. Accordingly, the OELD is attracting attention as a display device that can replace the LCD.

The OLED includes a light emitting layer. The light emitting layer includes an organic material. The organic material is deposited on the substrate using a deposition mask. The deposition mask may include an open mask (OM) or a fine metal mask (FMM). A deposition pattern corresponding to a pattern formed on a deposition mask is formed on the substrate. Accordingly, the deposition pattern may serve as a pixel.

The open mask is a thin plate that forms a deposition pattern only at a specific location when manufacturing an OLED. The open mask is used in a deposition process of forming a light emitting layer thereon after a backplane is completed in a display manufacturing process. That is, the open mask is a mask that does not cover a portion within an operating range of the display in order to deposit the entire surface of the display. Therefore, the open mask is used when depositing a light emitting layer with a light emitting material of one color.

On the other hand, the fine metal mask is used to change the color of the sub-pixels of the light emitting layer. Accordingly, the fine metal mask includes ultra-fine holes. The process of using the fine metal mask requires a multi-step deposition process. Therefore, the process requires accurate alignment. Accordingly, the process using the fine metal mask is more difficult than the process using the open mask.

When the light emitting layer of the OLED is deposited using an open mask, only a single-color light emitting layer is formed. Therefore, separate color filters are required to implement various colors. On the other hand, when using the fine metal mask, an RGB light emitting layer may be formed. Therefore, a separate color filter is not required. That is, the technique using the fine metal mask has a high degree of difficulty. However, compared to the method using an open mask, light efficiency is good because a filter for blocking light is not required.

The fine metal mask is generally made of an Invar alloy metal plate including iron (Fe) and nickel (Ni). Through-holes are formed through one surface and the other surface of the metal plate. The through-hole is formed at a position corresponding to the pixel pattern. Accordingly, red, green, and blue organic materials may pass through the through-hole of the metal plate and be deposited on the deposition substrate. Accordingly, a pixel pattern may be formed on the deposition substrate.

Meanwhile, the fine metal mask includes a small area hole formed on one surface of the metal plate and a large area hole formed on the other surface of the metal plate. The small face hole and the large area hole are connected by a connecting portion. As a result, the through-hole is formed.

The organic material is sprayed in the direction of the fine metal mask. The organic material is deposited on the deposition substrate using the large area hole as an inlet and the small area hole as an outlet.

The fine metal mask includes a plurality of through-holes. Therefore, when the shape or size of the plurality of through-holes is not uniform, the deposition reliability of the mask may decrease.

For example, the pixel pattern deposited on the deposition substrate may vary due to a difference in size or shape of the through-hole in a long axis direction and a short axis direction. Accordingly, deposition reliability of the fine metal mask may decrease.

Accordingly, there is a need for a deposition mask having a new structure capable of solving the above problems.

### [Disclosure]

### [Technical Problem]

The embodiment provides a deposition mask for OLED pixel deposition with improved deposition efficiency and deposition reliability.

### [Technical Solution]

A deposition mask comprising; a metal plate including a deposition region and a non-deposition region, wherein the deposition region includes at least one effective portion; wherein the effective portion includes a plurality of unit through-holes, wherein the unit through-holes include a small area hole formed on a first surface of the metal plate; a large area hole formed on a second surface of the metal plate; and a connecting portion connecting the small area hole and the large area hole, wherein a rib is disposed between unit through-holes adjacent in the first direction, wherein an island portion is disposed between the unit through-holes adjacent in the second direction, wherein the island portion includes a first island portion and a second island portion spaced apart from each other, wherein the first island portion contacts the rib, wherein the second island portion is spaced apart from the rib.

### [Advantageous Effects]

A deposition mask according to an embodiment includes at least one second island portion.

The second island portion protrudes toward the connecting portion. A shape and size of a unit through-hole is controlled by the second island portion.

In detail, a deviation of the inclination angle of the inner surface of the large area hole and a deviation of the height of the small area hole are reduced by the second island portion. Accordingly, the thickness of the deposition pattern deposited by one unit through-hole becomes uniform by the second island portion.

In addition, thickness deviation of deposition patterns deposited by a plurality of unit through-holes is reduced.

In addition, the uniformity of the size and/or shape of the plurality of unit through-holes is improved. Accordingly, the sizes and/or shapes of the deposition patterns formed by the plurality of unit through-holes become uniform.

Therefore, the deposition mask according to the embodiment has improved deposition efficiency and deposition reliability.

In addition, at least one of the inclination angle of the inner surface of the large area hole, a curvature of the inner surface of the large area hole, the height of the large area hole, and the height of the small area hole may be controlled to various sizes in different regions.

Therefore, in the deposition mask according to the embodiment, the shape or size of the large area hole and the small surface face hole may be adjusted in various ways according to the use environment.

Accordingly, the deposition mask according to the embodiment may have improved deposition efficiency.

### [Description of Drawings]

FIG. 1 is a view showing a combination of a deposition mask and a frame according to an embodiment.
FIG.2 is a cross-sectional view of an organic material deposition apparatus including the deposition mask according to the embodiment.
FIG. 3 is a view illustrating formation of a deposition pattern on a deposition substrate by through-holes of the deposition mask according to the embodiment.
FIG. 4 is a plan view of the deposition mask according to the embodiment.
FIG. 5 is a plan view of an effective portion of the deposition mask according to the embodiment.
FIG. 6 is a cross-sectional view taken along a region A-A' of FIG. 5.
FIG. 7 is a cross-sectional view taken along a region B-B' of FIG. 5.
FIG. 8 is a cross-sectional view taken along a region C-C' of FIG. 5.
FIG. 9 is an enlarged view of a unit through-hole of a deposition mask according to the embodiment.
FIGS. 10 and 11 are views for explaining a shape of the unit through-hole of the deposition mask according to the embodiment.
FIG. 12 is a cross-sectional view taken along a region D-D' of FIG. 5.
FIG. 13 is a cross-sectional view taken along a region E-E' of FIG. 5.
FIG. 14 is a cross-sectional view taken along a region F-F' of FIG. 5.

### [Modes of the Invention]

Hereinafter, embodiments of the present disclosure will be described in detail with reference to the accompanying drawings. However, the spirit and scope of the present disclosure is not limited to a part of the embodiments described, and may be implemented in various other forms, and within the spirit and scope of the present disclosure, one or more of the elements of the embodiments may be selectively combined and replaced. In addition, unless expressly otherwise defined and described, the terms used in the embodiments of the present disclosure (including technical and scientific terms) may be construed the same meaning as commonly understood by one of ordinary skill in the art to which the present disclosure belongs, and the terms such as those defined in commonly used dictionaries may be interpreted as having a meaning that is consistent with their meaning in the context of the relevant art.

In addition, the terms used in the embodiments of the present disclosure are for describing the embodiments and are not intended to limit the present disclosure. In this specification, the singular forms may also include the plural forms unless specifically stated in the phrase, and may include at least one of all combinations that may be combined in A, B, and C when described in "at least one (or more) of A (and), B, and C".

Further, in describing the elements of the embodiments of the present disclosure, the terms such as first, second, A, B, (a), and (b) may be used. These terms are only used to distinguish the elements from other elements, and the terms are not limited to the essence, order, or order of the elements.

In addition, when an element is described as being "connected", "coupled", or "connected" to another element, it may include not only when the element is directly "connected" to, "coupled" to, or "connected" to other elements, but also when the element is "connected", "coupled", or "connected" by another element between the element and other elements.

Further, when described as being formed or disposed "on (over)" or "under (below)" of each element, the "on (over)" or "under (below)" may include not only when two elements are directly connected to each other, but also when one or more other elements are formed or disposed between two elements.

Furthermore, when expressed as "on (over)" or "under (below)", it may include not only the upper direction but also the lower direction based on one element.

Hereinafter, a deposition mask according to an embodiment will be described with reference to the drawings.

The deposition mask described below is a fine metal mask capable of forming an RGB pixel pattern on the deposition substrate by depositing red, green, and blue organic materials on the deposition substrate. In addition, the following description does not apply to the open mask.

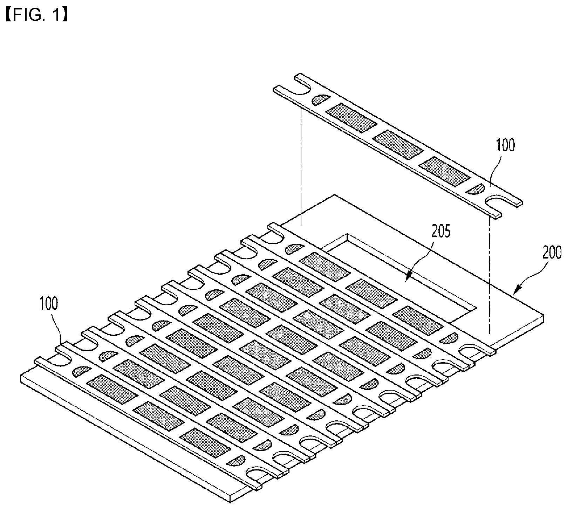

FIGS 1 to 3 are views for explaining a process of depositing an organic material on a deposition substrate 300 using a deposition mask 100 according to an embodiment.

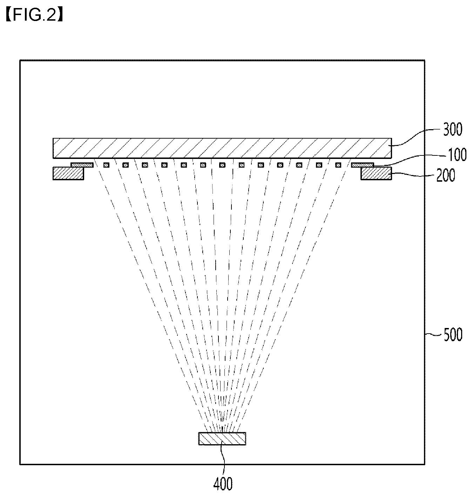

Referring to FIGS. 1 and 2, the organic material deposition apparatus includes a deposition mask 100, a mask frame 200, a deposition substrate 300, an organic material deposition container 400 and a vacuum chamber 500.

The deposition mask 100 includes metal. For example, the deposition mask includes iron (Fe) and nickel (Ni). In detail, the deposition mask includes an invar alloy including iron (Fe) and nickel (Ni).

The deposition mask 100 includes a plurality of through-holes TH. The through-hole is disposed in the effective portion. The through-hole is disposed to correspond to a pixel pattern to be formed on the deposition substrate. The deposition mask 100 includes a non-effective portion other than an effective portion including a deposition region.

The mask frame 200 includes an opening 205. The plurality of through-holes are disposed on a region corresponding to the opening 205. Accordingly, the organic material supplied to the organic material deposition container 400 is deposited on the deposition substrate 300. The deposition mask 100 is disposed and fixed on the mask frame 200. For example, the deposition mask 100 is tensioned with a set tensile force. In addition, the deposition mask 100 is welded and fixed on the mask frame 200.

For example, the non-effective portion of the deposition mask 100 is welded. Accordingly, the deposition mask 100 is fixed on the mask frame 200. Then, the portion protruding out of the mask frame 200 is cut and removed.

The mask frame 200 includes metal having high rigidity. Thus, deformation of the mask frame during the welding process is reduced.

The deposition substrate 300 is a substrate used when manufacturing a display device. For example, an OLED pixel pattern is formed on the deposition substrate 300. Red, green, and blue organic patterns are formed on the deposition substrate 300 to form pixels that are three primary colors of light. That is, an RGB pattern is formed on the deposition substrate 300.

The organic material deposition container 400 is a crucible. The organic material is disposed inside the crucible. The organic material deposition container 400 moves inside the vacuum chamber 500. That is, the organic material deposition container 400 moves in one direction inside the vacuum chamber 500. For example, the organic material deposition container 400 moves in the width direction of the deposition mask 100 inside the vacuum chamber 500.

A heat source and/or current is supplied to the organic material deposition container 400. As a result, the organic material is deposited on the deposition substrate 300.

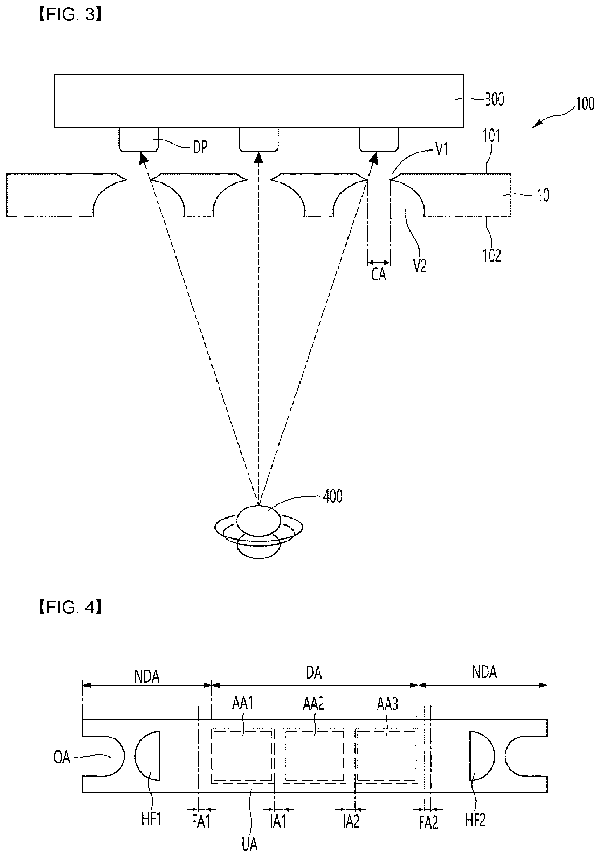

Referring to FIG. 3, the deposition mask 100 includes a metal plate 10. The metal plate includes a first surface 1S and a second surface 2S. The first surface 1S and the second surface 2S are opposite to each other.

The first surface 1S includes a small area hole V1. The second surface 2S includes a large area hole V2. For example, a plurality of small area holes V1 and a plurality of large area holes V2 are formed on the first surface 1S and the second surface 2S, respectively.

In addition, the deposition mask 100 includes a through-hole TH. The through-hole TH is formed by a connection portion CA connecting the boundary between the small area hole V1 and the large area hole V2.

The width of the large area hole V2 is greater than that of the small area hole V1. The width of the small area hole V1 is measured on the first surface 1S of the deposition mask 100. The width of the large area hole V2 is measured on the second surface 2S of the deposition mask 100.

Also, a width of the connection portion CA has a set size. In detail, the width of the connection portion CA may be 15 µm to 33 µm. In more detail, the width of the connection portion CA may be 19 µm to 33 µm. In more detail, the width of the connection portion CA may be 20 µm to 27 µm. When the width of the connection portion CA exceeds 33 µm, it is difficult to implement a resolution of 500 PPI or higher. In addition, when the width of the connection portion CA is less than 15 µm, defects may occur during the deposition process.

The small area hole V1 faces the deposition substrate 300. The small area hole V1 is disposed close to the deposition substrate 300. Accordingly, the small area hole V1 has a shape corresponding to a deposition pattern DP.

The large area hole V2 faces the organic material deposition container 400. Accordingly, the organic material supplied from the organic material deposition container 400 may be accommodated in a wide width by the large area hole V2. In addition, a fine pattern may be rapidly formed on the deposition substrate 300 by the small area hole V1.

Accordingly, the organic material accommodated by the large area hole V2 is deposited on the deposition substrate 300 by the small area hole V1. Accordingly, any one of red, green, and blue pixel patterns is formed on the deposition substrate 300. Then, the above process is repeated. Accordingly, red, green, and blue pixel patterns are all formed on the deposition substrate 300.

FIG. 4 is a plan view of a deposition mask 100 according to the embodiment.

Referring to FIG. 4, the deposition mask 100 includes a deposition region DA and a non-deposition region NDA.

The deposition region DA is a region for forming the deposition pattern. The deposition region DA includes a pattern region and a non-pattern region. The pattern region is a region including the small area hole V1, the large area hole V2, the through-hole TH, and the island portion IS. The non-pattern region is a region that does not include the small area hole V1, the large area hole V2, the through-hole TH, and the island portion IS. The deposition region DA may be defined as a region from an initial start point to an end point of a through-hole or hole in the longitudinal direction of the deposition mask 100.

Also, the deposition region DA includes a plurality of effective portions AA1, AA2, and AA3. A plurality of deposition patterns may be formed by the effective portion. In detail, the pattern region includes the plurality of effective portions AA1, AA2, and AA3.

The deposition region DA includes a plurality of separation regions IA1 and IA2. Separation regions IA1 and IA2 are disposed between adjacent effective portions. The separation regions IA1 and IA2 are spaced regions between the plurality of effective portions. Adjacent effective portions may be distinguished from each other by the separation regions IA1 and IA2. In addition, one deposition mask 100 may support a plurality of effective portions.

The non-deposition region NDA is a region not involved in deposition. The non-deposition region NDA includes frame fixing regions FA1 and FA2. The frame fixing regions FA1 and FA2 are regions for fixing the deposition mask 100 to the mask frame 200. Also, the non-deposition region NDA may include half-etched portions HF1 and HF2 and an open portion.

The half etching portions HF1 and HF2 may disperse stress generated when the deposition mask 100 is tensioned.

In addition, the open portion may disperse stress generated when the deposition mask 100 is tensioned. Accordingly, deformation of the deposition mask may be reduced.

As described above, the deposition mask 100 includes the through-hole. The through-hole is a passage through which the organic material moves.

The through-hole is formed by the small area hole, the large area hole, and the connecting portion. The metal plate includes a plurality of through-holes. In detail, the effective portion includes a plurality of through-holes.

When an angle of an inner surface, and a height, or the size of the small area hole in the long axis direction and the short axis direction are not uniform inside one through-hole, the amount of deposition material moving through the through-hole may be changed. In addition, a difference in the distance between the deposition mask and the deposition substrate may occur. Thereby, the thickness of the deposition pattern may not be uniform.

In addition, when the shape and/or size of the plurality of through-holes are not uniform, the size or shape deviation of the deposition patterns deposited on the deposition substrate may increase. Accordingly, the deposition reliability of the deposition mask may be reduced.

Hereinafter, the deposition mask capable of solving the above-described deposition non-uniformity will be described.

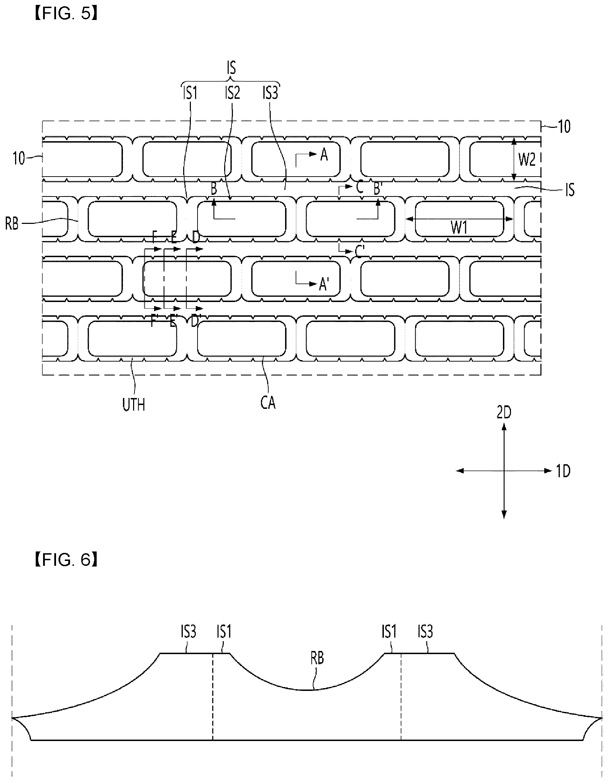

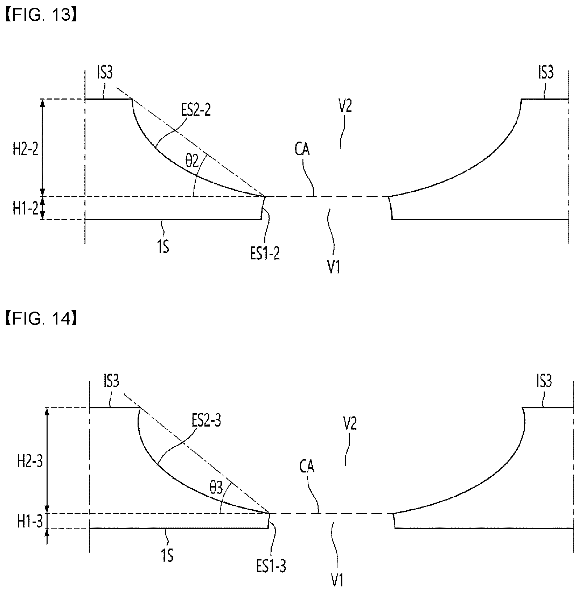

Hereinafter, the deposition mask according to the embodiment will be described with reference to FIGS. 5 to 14.

Referring to FIGS 5 to 14, the deposition mask 100 includes a plurality of through-holes. In detail, the deposition mask 100 includes a plurality of unit through-holes UTH. The unit through-hole UTH is formed by the small area hole V1, the large area hole V2 and the connection portion CA.

The unit through-hole UTH includes a first width W1 in a first direction 1D and a second width W2 in a second direction 2D. The first direction 1D and the second direction 2D may be a longitudinal direction or a width direction of the deposition mask 100. For example, the first direction 1D may be a longitudinal direction of the deposition mask 100. Also, the second direction 2D may be a width direction of the deposition mask 100. In addition, the size of the width is defined as the size of the width of the large area hole V2.

The first width W1 and the second width W2 are different. For example, the first width W1 is greater than the second width W2. Accordingly, the unit through-hole UTH has a long width in the first direction and a short width in the second direction.

However, the embodiment is not limited thereto. The first width and the second width may be the same or similar.

A rib RB and an island portion IS are disposed between the plurality of unit through-holes UTH. The rib RB is a region where the metal plate 10 is partially etched. In addition, the island portion IS is a region where the metal plate 10 is not etched.

Referring to FIGS. 6 to 8, the island portion IS is a surface on which one surface of the metal plate is not etched. In addition, the rib RB is a region of a side or a region of a surface where two surfaces meet when the metal plate 10 is partially etched. For example, the rib RB may be a side or a surface where the inner surfaces ES of the through-hole meet. A longitudinal direction of the rib RB may extend in the second direction.

The rib RB is disposed between unit through-holes UTH adjacent in the first direction 1D. In addition, the island portion IS is disposed between unit through-holes UTH adjacent in the second direction 2D.

The island portion IS includes a first island portion IS1, a second island portion IS2, and a third island portion IS3. The first island part IS1, the second island part IS2, and the third island part IS3 are connected.

Referring to FIGS. 5 to 8, the first island portion IS1 and the second island portion IS2 spaced apart from each other. Also, the third island portion IS3 is connected to the first island portion IS1 and the second island portion IS2. Accordingly, the first island portion IS1 and the second island portion IS2 are connected by the third island portion IS3. That is, the first island portion IS1 and the second island portion IS2 do not contact each other. However, the first island portion IS1 and the second island portion IS2 are connected by the third island portion IS3.

The first island portion IS1 is disposed between the adjacent unit through-holes UTH1 and UTH2. In detail, the first island portion IS1 is disposed between the unit through-holes UTH adjacent to each other in the first direction 1D. The first island portion IS1 contacts the rib RB. For example, the rib RB connects adjacent first island portions IS1. Accordingly, one end of the first island portion IS1 is connected to the third island part IS3 in the second direction 2D. Also, the other end of the first island portion IS1 is connected to the rib RB.

The second island portion IS2 protrudes in the direction of the connection portion CA of the unit through-hole UTH. In detail, the second island portion IS2 protrudes in the second direction 2D from the third island portion IS3. The second island portion IS2 is spaced apart from the rib RB. That is, the second island portion IS2 does not contact the rib RB. The second island part IS2 is connected to the third island part IS3. The second island portion IS2 includes at least one island portion. For example, the second island portion IS2 includes a plurality of island portions.

The second island portion IS is connected to the inner surface ES of the through-hole. Accordingly, one end of the second island portion IS2 is connected to the third island part IS3 in the second direction 2D. Also, the other end of the second island portion IS2 is connected to the inner surface ES of the through-hole.

The third island portion IS3 is disposed between adjacent unit through-holes UTH. In detail, the third island portion IS3 is disposed between the unit through-holes UTH adjacent to each other in the second direction 2D. The third island portion IS3 is spaced apart from the rib RB. That is, the third island portion IS3 does not contact the rib RB. The third island portion IS3 is connected to the first island portion IS1 and the second island portion I3. In detail, one end of the third island part IS3 is connected to the first island portion IS1 and the second island part IS2 in the second direction 2D. Also, the other end of the third island portion IS3 is connected to the first island portion IS1 and the second island portion IS2.

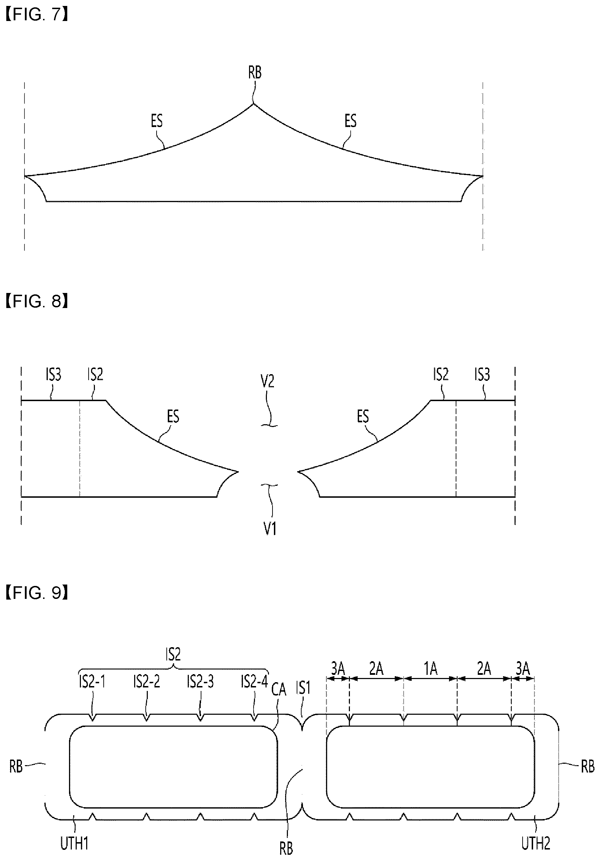

Referring to FIG. 9, the unit through-holes UTH1 and UTH2 are divided into a plurality of regions. In detail, the unit through-holes UTH1 and UTH2 are divided into a plurality of regions by the second island portion IS2.

For example, the unit through-holes UTH1 and UTH2 include a first region 1A, a second region 2A, and a third region 3A. That is, the second island portion IS2 includes a plurality of second island portions. Accordingly, the unit through-holes UTH1 and UTH2 are divided into a plurality of regions.

In the drawing, it is shown that the second island portion IS2 includes a 2-1 island portion IS2-1, a 2-2 island portion IS2-2, a 2-3 island portion IS2-3, and a 2-4 island portion IS2-4. In addition, it is shown that the unit through-holes UTH1 and UTH2 include a first region 1A, a second region 2A, and a third region 3A. However, the embodiment is not limited thereto. The second island portion may include less than four or more than four second island portions. Alternatively, the number of regions of the unit through-holes UTH1 and UTH2 may vary.

The first region 1A is disposed in the central region of the unit through-holes UTH1 and UTH2. In addition, the third region 3A is disposed in an outer region of the unit through-holes UTH1 and UTH2. Also, the second region 2A is disposed between the first region 1A and the third region 3A. Accordingly, two second regions 2A are disposed adjacent to the first region 1A in the first direction 1D. In addition, two third regions 3A are disposed adjacent to the second region 2A in the first direction 1D.

The size of each region of the unit through-hole is made uniform by the second island portion IS2. Also, the deviation of the plurality of unit through-holes is reduced by the second island portion IS2. Also, the shapes of the plurality of unit through-holes become uniform.

In detail, the deviation of the inclination angle of the inner surface of the large area hole and the deviation of the height of small area hole in the first to third regions are reduced by the second island portion IS2.

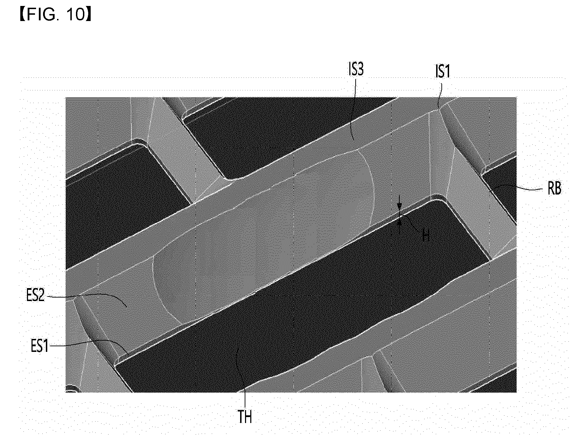

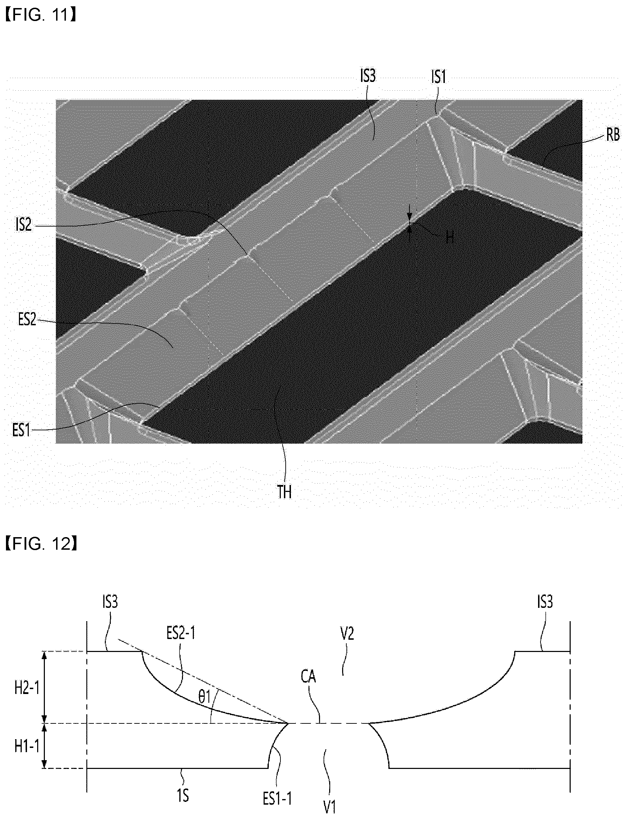

FIGS. 10 and 11 are views for explaining the deviation of the inclination angle of the inner surface of the large area hole and the deviation of the height of the small area hole, which are different due to the existence of the second island portion.

Referring to FIG. 10, when the second island portion is not included, the central region of the unit through-hole is etched relatively more than the outer region.

In detail, the inner surface ES2 of the large area hole V2 has a different etching degree for each region. In detail, when forming the through-hole, the etchant may concentrate toward the central region rather than the outer region. Accordingly, the etching amount of the central region may be greater than the etching amount of the outer region.

Accordingly, in the central region of the unit through-hole, the inclination angle of the inner surface ES2 of the large area hole increases, and the height H of the inner surface ES1 of the small area hole decreases. Therefore, the deviation of the inclination angle of the inner surface of the large area hole and the deviation of the height of the inner surface of the small area hole between the central region and the outer region of the through-hole increase.

Accordingly, deviations in inclination angles and heights increase between the central region and the outer region of the finally manufactured unit through-hole. When the outer region is controlled to be 6 µm or less in order to control the height of the small area hole to be 6 µm or less, the height of the small area hole in the central region approaches 0. Accordingly, the deposition pattern deposited on the deposition substrate and the deposition material remaining in the deposition mask may be connected. Therefore, when the deposition mask is removed, the deposition pattern may be de-filmed. On the other hand, when the height of the small area hole in the central region is controlled to be 6 µm or less, the outer region is formed to be 10 µm or more. Accordingly, the deposition pattern may not be deposited on the deposition substrate corresponding to the outer region.

For example, a large amount of deposition material may enter the central region and a small amount of deposition material may enter the outer region. In addition, the distance between the deposition mask and the deposition substrate may be short in the central region, and the distance between the deposition mask and the deposition substrate may be long in the outer region. Accordingly, the thickness deviation of the deposition pattern formed by the central region and the outer region of the unit through-hole increases. Accordingly, the deposition reliability of the deposition mask may decrease.

In addition, a thickness deviation of deposition patterns formed by a plurality of unit through-holes may increase. Also, the shapes and/or sizes of the deposition patterns may become non-uniform. Accordingly, the deposition reliability of the deposition mask may be reduced.

On the other hand, referring to FIG. 11, when the second island portion IS2 is included, the deviations of the unit through-hole may be reduced. Also, the shape and/or size of the deposition patterns formed by the plurality of unit through-holes may be made uniform.

In detail, the inner surface ES2 of the large area hole V2 and the inner surface ES1 of the small area hole V1 may be divided into a plurality of regions by the second island portion IS2.

The unit through-hole may be formed by individually etching the plurality of regions instead of etching them all at once. Accordingly, the deviation of the inclination angle of the inner surface ES2 of the large area hole V2 is reduced in each region of the unit through-hole. Also, the deviation of the height of the inner surface ES1 of the small area hole V1 is reduced.

Accordingly, the deviation of the inclination angle of the inner surface ES2 of the large area hole V2 of the plurality of regions of the unit through-hole is reduced, and the deviation of the height H of the inner surface ES1 of the small area hole V1 is reduced.

Preferably, the deviation of the inclination angle of the inner surface ES2 of the large area hole V2 of the plurality of regions of the unit through-hole may be 20° or less, 10° or less, 5° or less, or 2° or less. In addition, the deviation of the height H of the inner surface ES of the small area hole V1 and/or the large area hole V2 may be 5 µm or less, 4 µm or less, 3 µm or less, 2 µm or less, or 1 µm or less.

Therefore, the deviation of the inclination angle of the inner surface ES2 of the large area hole V2 and the deviation of the height of the inner surface ES1 of the small area hole V1 are reduced in the central and outer regions of the finally manufactured unit through-hole. Accordingly, when a deposition pattern is formed by the unit through-hole, a thickness deviation is reduced between the central region and the outer region of the unit through-hole. Accordingly, deposition reliability of the deposition mask may be improved.

In addition, thickness deviation of deposition patterns formed by a plurality of unit through-holes is reduced. Also, the shapes and/or sizes of the deposition patterns become uniform. Accordingly, deposition reliability of the deposition mask may be improved.

Meanwhile, in the deposition mask 100, the shape and size of the inner surface of the unit through-hole may be formed in various ways by the second island portion. In detail, in the deposition mask 100, the height of the inner surface of the small area hole V1 and the inclination angle of the inner surface of the large area hole V2 may be formed to have various sizes for each region.

FIGS. 12 to 14 are cross-sectional views of first to third regions of the unit through-hole. The first region is a central region of the unit through-hole based on the first direction. The third region is an outer region of the unit through-hole. The second region is a region between the first region and the third region.

Referring to FIGS. 12 to 14, the first region 1A of the large area hole includes a 2-1 inner surface ES2-1 in the first direction 1D. In addition, the first region 1A of the small area hole includes a 1-1 inner surface ES1-1 in the first direction 1D.

In addition, the 2-1 inner surface ES2-1 has a curvature. In addition, the 2-1 inner side surface ES2-1 has a first inclination angle θ1. In addition, the large area hole of the first region 1A has a 2-1 height H2-1. In addition, the small area hole of the first region 1A has a 1-1 height H1-1.

The second region 2A of the large area hole includes a 2-2 inner surface ES2-2 in the first direction 1D. In addition, the second region 2A of the small area hole includes the 1-2 inner surface ES1-2 in the first direction 1D.

In addition, the 2-2 inner surface ES2-2 has a curvature. In addition, the 2-2 inner surface ES2-2 has a second inclination angle θ2. In addition, the large area hole of the second region 2A has a 2-2 height H2-2. In addition, the small area hole of the second region 2A has a 1-2 height H1-2.

The third region 3A of the large area hole includes the 2-3 inner surface ES2-3 in the first direction 1D. In addition, the third region 3A of the small area hole includes the 1-3 inner surfaces ES1-3 in the first direction 1D.

In addition, the 2-3 inner surface ES2-3 has a curvature. In addition, the 2-3 inner surface ES2-3 has a third inclination angle θ3. Also, the large area hole of the third region 3A has a 2-3 height H2-3. In addition, the small area hole of the third region 3A has a 1-3 height H1-3.

A virtual line connecting one end of the connecting portion CA and one end of the large area hole V2 may be defined. The inclination angle of the large area hole V2 is an acute angle formed by the virtual line and the extension line of the connecting portion CA. In addition, the height of the large area hole is the vertical height from the connecting portion CA to the island portion IS3. In addition, the height of the small area hole V1 is the vertical height from the connection portion CA to the first surface. In addition, the curvature is defined as the reciprocal of the radius of curvature (um).

The 2-1 inner surface ES2-1, the 2-2 inner surface ES2-2, and the 2-3 inner surface ES2-3 may have different inclination angles. In addition, the 2-1 inner surface ES2-1, the 2-2 inner surface ES2-2, and the 2-3 inner surface ES2-3 may have different curvatures. In addition, the 1-1 inner surface ES1-1, the 1-2 inner surface ES1-2, and the 1-3 inner surface ES1-3 may have different heights.

Referring to FIGS. 12 to 14, the third inclination angle θ3 may be greater than the first inclination angle θ1 and the second inclination angle θ2. Also, the second inclination angle θ2 may be greater than the first inclination angle θ1. Accordingly, the inclination angle of the inner surface of the large area hole may decrease while extending from the outer region to the central region.

In addition, the curvature of the 2-3 inner surface ES2-3 may be greater than the curvature of the 2-1 inner surface ES2-1 and the curvature of the 2-2 inner surface ES2-2. Also, the curvature of the 2-2 inner surface ES2-2 may be greater than the curvature of the 2-1 inner surface ES2-1. Accordingly, the curvature of the inner surface of the large area hole may decrease while extending from the outer region to the central region.

In addition, the height of the 1-1 inner surface ES1-1 may be greater than the heights of the 1-2 inner surface ES1-2 and the 1-3 inner surface ES1-3. Also, the height of the 1-2 inner surface ES1-2 may be greater than the height of the 1-3 inner surface ES1-3. Accordingly, the height of the inner surface of the small area hole may increase while extending from the outer region to the central region.

However, the embodiment is not limited thereto. That is, the inclination angle, curvature, and height of the inner surface of the large area hole and the height of the small area hole may be formed in various ways depending on the region.

For example, the first inclination angle θ1 may be greater than the second inclination angle θ2 and the third inclination angle θ3. Also, the second inclination angle θ2 may be greater than the third inclination angle θ3. Accordingly, the inclination angle of the inner surface of the large area hole may increase while extending from the outer region to the central region.

In addition, the curvature of the 2-1 inner surface ES2-1 may be greater than the curvature of the 2-2 inner surface ES2-2 and the curvature of the 2-3 inner surface ES2-3. Also, the curvature of the 2-2 inner surface ES2-2 may be greater than the curvature of the 2-3 inner surface ES2-3. Accordingly, the curvature of the inner surface of the large area hole may increase while extending from the outer region to the central region.

Also, the height of the 1-3 inner side surface ES1-3 may be greater than the height of the 1-1 inner side surface ES1-1 and the height of the 1-2 inner side surface ES1-2. Also, the height of the 1-2 inner surface ES1-2 may be greater than the height of the 1-1 inner surface ES1-1. Accordingly, the height of the inner surface of the small area hole may decrease while extending from the outer region to the central region.

Alternatively, the second inclination angle θ2 may be greater than the first inclination angle θ1 and the third inclination angle θ3. Also, the first inclination angle θ1 and the third inclination angle θ3 may be the same. Alternatively, the first inclination angle θ1 and the third inclination angle θ3 may be different. For example, the first inclination angle θ1 may be greater than the third inclination angle θ3. Alternatively, the third inclination angle θ3 may be greater than the first inclination angle θ1. Accordingly, the inclination angle of the inner surface of the large area hole may increase and then decrease while extending from the central region to the outer region.

In addition, the curvature of the 2-2 inner surface ES2-2 may be greater than the curvature of the 2-1 inner surface ES2-1 and the curvature of the 2-3 inner surface ES2-3. Also, the curvature of the 2-1 inner surface ES1 and the 2-3 inner surface ES2-3 may be the same. Alternatively, the curvature of the 2-1 inner surface ES2-1 and the 2-3 inner surface ES2-3 may be different. For example, the curvature of the 2-1 inner surface ES2-1 may be greater than the curvature of the 2-3 inner surface ES2-3. Alternatively, the curvature of the 2-3 inner surface ES2-3 may be greater than the curvature of the 2-1 inner surface ES2-1. Accordingly, the curvature of the inner surface of the large area hole may increase and then decrease while extending from the central region to the outer region.

Alternatively, the height of the 1-2 inner side surface ES1-2 may be smaller than the height of the 1-1 inner side surface ES1-1 and the height of the 1-3 inner side surface ES1-3. Also, the height of the 1-1 inner surface ES1-1 and the height of the 1-3 inner surface ES1-3 may be the same. Alternatively, the height of the 1-1 inner surface ES1-1 and the height of the 1-3 inner surface ES1-3 may be different. For example, the height of the 1-1 inner surface ES1-1 may be greater than the height of the 1-3 inner surface ES1-3. Alternatively, the height of the 1-3 inner side surface ES1-3 may be greater than the height of the 1-1 inner side surface ES1-1. Accordingly, the height of the inner surface of the small area hole may increase and then decrease while extending from the central region to the outer region.

In the absence of the second island portion, the shape of the inner surface of the large area hole is formed such that the inclination angle decreases and the curvature increases while extending from the central region to the outer region through an etching process. In addition, the shape of the small area hole was formed to increase in height while extending from the central region to the outer region.

However, in the deposition mask according to the embodiment, the etching degree of the inner surface of the large area hole may be controlled for each region by the second island portion. Therefore, as described above, the inclination angle and curvature of the inner surface of the large area hole and the height of the small area hole may be varied.

Therefore, the inclination angle of the inner surface, the curvature of the inner surface, the height of the large area hole, and the height of the small area hole may be formed in various ways according to the positions of the large area hole and the small area hole based on the first direction.

Accordingly, at least one of the shapes of the large area hole, the size of the large area hole, and the size of the small surface face hole may be formed in various sizes or shapes according to the environment in which the deposition mask is used.

For example, it is necessary to adjust the inclination angle of the inner surface of the large area hole in order to reduce the height deviation of the small area hole. In this case, since the height of the small area hole in the central region is too low compared to that of the outer region, the deposition pattern may be de-filmed. In this case, by forming the angle of the large area hole in the central region small, the height of the small area hole in the central region may be increased. In addition, depending on conditions of the organic material deposition apparatus, a small amount of deposition material is deposited in the outer region of the unit through-hole, and thus the light efficiency of the deposition pattern may be low. In this case, the angle of the large area hole in the outer region of the unit through-hole may be increased or the height of the small area hole may be reduced. Accordingly, light efficiency of the deposition pattern may be improved by increasing the thickness of the deposition pattern deposited in the outer region. Accordingly, the deposition mask has improved deposition efficiency. Also, deposition reliability of a unit deposition region corresponding to the unit through-hole may be improved.

The deposition mask according to the embodiment includes a plurality of second island portions.

The second island portion protrudes toward the connecting portion. The shape and size of the unit through-hole is controlled by the second island portion. That is, the shape of the unit through-hole may be uniform for each region by the second island portion. In addition, the deviation of the inclination angle of the inner surface of the large area hole and the deviation of the height of the small area hole of the plurality of regions of the unit through-hole may be reduced by the second island portion. Also, the shape and size of the plurality of unit through-holes may be uniform.

Accordingly, thickness uniformity of the deposition pattern formed by the unit through-hole may be improved. In addition, the thickness and shape of the deposition pattern formed through the plurality of unit through-holes become uniform.

Accordingly, the deposition mask according to the embodiment has improved deposition efficiency and deposition reliability.

The characteristics, structures, effects, and the like described in the above-described embodiments are included in at least one embodiment of the present invention, but are not limited to only one embodiment. Furthermore, the characteristic, structure, and effect illustrated in each embodiment may be combined or modified for other embodiments by a person skilled in the art. Accordingly, it is to be understood that such combination and modification are included in the scope of the present invention.

In addition, embodiments are mostly described above, but the embodiments are merely examples and do not limit the present invention, and a person skilled in the art may appreciate that several variations and applications not presented above may be made without departing from the essential characteristic of embodiments. For example, each component specifically represented in the embodiments may be varied. In addition, it should be construed that differences related to such a variation and such an application are included in the scope of the present invention defined in the following claims.

## Claims

1. A deposition mask comprising;
a metal plate including a deposition region and a non-deposition region,
wherein the deposition region includes at least one effective portion;
wherein the effective portion includes a plurality of unit through-holes,
wherein the unit through-holes include a small area hole formed on a first surface of the metal plate; a large area hole formed on a second surface of the metal plate; and a connecting portion connecting the small area hole and the large area hole,
wherein a rib is disposed between unit through-holes adjacent in the first direction,
wherein an island portion is disposed between the unit through-holes adjacent in the second direction,
wherein the island portion includes a first island portion and a second island portion spaced apart from each other,
wherein the first island portion contacts the rib,
wherein the second island portion is spaced apart from the rib.

2. The deposition mask of claim 1, further comprising a third island portion connected to the first island portion and the second island portion,
wherein the third island portion extends in the first direction.

3. The deposition mask of claim 2, wherein the second island portion protrudes from the third island portion toward the connecting portion.

4. The deposition mask of claim 1, wherein one end of the first island portion is connected to the third island portion, and the other end is connected to the rib;
wherein one end of the second island portion is connected to the third island portion, and the other end is connected to the inner surface of the unit through-hole.

5. The deposition mask of claim 1, wherein the second island portion includes a plurality of island portions.

6. The deposition mask of claim 1, wherein an inner surface of the large area hole includes a first region, a second region, and a third region divided by the second island portion,
wherein the first region is disposed in the central region of the inner surface of the large area hole,
wherein the third region is disposed in the outer region of the inner surface of the large area hole,
wherein the second region is disposed between the first region and the third region.

7. The deposition mask of claim 6, wherein an inclination angles of inner surfaces of the large area holes of the first region, the second region, and the third region are different.

8. The deposition mask of claim 6, wherein curvatures of inner surfaces of the large area holes of the first region, the second region, and the third region are different.

9. The deposition mask of claim 6, wherein heights of the large area holes of the first region, the second region, and the third region are different,

10. The deposition mask of claim 6, wherein heights of the small area holes of the first region, the second region, and the third region are different.
